(19) Europäisches Patentamt

European Patent Office

Office européen des brevets

(11) Veröffentlichungsnummer: **0 259 909 B1**

(12) **EUROPÄISCHE PATENTSCHRIFT**

(45) Veröffentlichungstag der Patentschrift: **13.05.92**

(21) Anmeldenummer: **87201529.2**

(22) Anmeldetag: **12.08.87**

(51) Int. Cl.⁵: **H01S 3/085**, H01S 3/098, H01S 3/043, H04B 10/04

(54) **Optischer Sender mit einem Halbleiterlaser und einem externen Resonator.**

(30) Priorität: **14.08.86 DE 3627649**

(43) Veröffentlichungstag der Anmeldung:
**16.03.88 Patentblatt 88/11**

(45) Bekanntmachung des Hinweises auf die Patenterteilung:
**13.05.92 Patentblatt 92/20**

(84) Benannte Vertragsstaaten:
**DE FR GB IT SE**

(56) Entgegenhaltungen:
**DE-A- 3 311 808**

**APPLIED PHYSICS LETTERS, Band 49, Nr. 1, Juli 1986, Seiten 10-12, New York, US; S.K. KOROTKY et al.: "Integrated-optic, narrow-linewidth laser"**

(73) Patentinhaber: **Philips Patentverwaltung GmbH
Wendenstrasse 35 Postfach 10 51 49
W-2000 Hamburg 1(DE)**

(84) Benannte Vertragsstaaten:
**DE**

(73) Patentinhaber: **N.V. Philips' Gloeilampenfabrieken
Groenewoudseweg 1
NL-5621 BA Eindhoven(NL)**

(84) Benannte Vertragsstaaten:
**FR GB IT SE**

(72) Erfinder: **Rybach, Johannes, Dr. rer. nat.
Forellenweg 39
W-4018 Langenfeld(DE)**
Erfinder: **Fuchs, Manfred Heinrich, Dr.
Gr. Bahnstrasse 4
W-2000 Hamburg 54(DE)**

(74) Vertreter: **Koch, Ingo, Dr.-Ing. et al
Philips Patentverwaltung GmbH Wendenstrasse 35 Postfach 10 51 49
W-2000 Hamburg 1(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf einen optischen Sender mit einem Halbleiterlaser und einem externen, als Längenabschnitt eines Monomode-Lichtwellenleiter (LWL) ausgebildeten Resonator, durch welchen ein Teil des vom Halbleiterlaser gesendeten Lichts in den Halbleiterlaser zurückgekoppelt wird.

Optische Systeme mit Überlagerungsempfang benötigen Sender mit so geringen Bandbreiten, daß Halbleiterlaser ohne zusätzliche Maßnahmen den Anforderungen nicht genügen. In jedem Fall muß der von den Schnittflächen des Halbleiterkristalls gebildete kurze Resonator erweitert werden um einen möglichst langen und frequenzselektiven externen Resonator. Es muß also ein definierter Anteil der emittierten Strahlung kohärent rückgekoppelt werden. Bekannt geworden sind Rückkoppelungen durch Spiegel, Filter und Einmodenfasern.

Eine Anordnung der eingangs genannten Art ist durch "Electronics Letters", Vol. I8, No. 9, I982, Seiten 353-354 bekannt. Diese ermöglicht sehr kleine Laserlinienbreiten.Dabei kann die Faser entweder an den rückwärtigen Ausgang eines offenen Halbleiterlaser-Kristalls angekoppelt oder an das "pig-tail" eines geschlossenen Lasers angespleißt werden. Von praktischer Bedeutung ist die letztgenannte Möglichkeit. Dabei besteht jedoch der Nachteil, daß die Polarisationsebene der aus dieser Faser austretenden Strahlung rotiert, wenn thermische oder mechanische Faserbeanspruchungen auftreten, wie sie außerhalb des Labors unvermeidlich sind. Damit ist der Einsatz solcher Halbleiterlaser als Strahlungsquellen wie z.B. als Lokaloszilatoren für heterodyne Empfangssysteme mit erforderlicher kohärenter Überlagerung stark eingeschränkt.

Auch können optische Isolatoren, die auf magneto-optischen Effekten (Faraday-Effekt) basieren, nicht verwendet werden, weil ihnen eine genau definierte Polarisationsebene des Lichts zugeordnet werden muß. Die optische Isolation des Senders ist jedoch notwendig, wenn Reflexe aus angekoppelten Faserstrecken bis hinünter zu ca. 60 dB unter der Ausgangsleistung die spektralen Eigenschaften von Halbleiterlasern nicht merkbar beeinträchtigen sollen.

Der Erfindung liegt die Aufgabe zugrunde, einen optischen Sender geringer Bandbreite der eingangs genannten Art zu schaffen, dessen Ausgangslicht seine Polarisationsrichtung definiert beibehält.

Die Lösung gelingt dadurch, daß der Monomode-LWL-Resonator an einen Abzweig eines in den Sendelichtweg geschalteten Strahlteilers angeschlossen ist.

Erfindungsgemäß braucht das eigentliche Sendelicht nicht mehr eine lange Vorlauffaser zu durchlaufen, so daß keine undefinierten Drehungen der Polarisationsebene mehr verursacht werden können.

Für die Erfindung sind beliebige bekannte Strahlteiler geeignet, vorzugsweise jedoch Faserkoppler. Diese können vorteilhaft so dimensioniert werden, daß in den Monomode-LWL-Resonator weniger als 50% des vom Laser gesendeten Lichts geleitet ist. Der direkte Durchgangsweg wird dann bevorzugt, so daß mehr Nutzlicht zur Verfügung steht.

Es ist weiterhin vorteilhaft möglich, an den Ausgang des Monomode-LWL-Resonators eine Meßeinrichtung anzuschließen, statt diesen Ausgang zu versumpfen.

Mittels kohärenter Rückstreuung eingeengte Halbleiterlaser haben die Eigenschaft, innerhalb des Verstärkungsprofils um Beträge von ca. I0 bis 50 MHz mit einer Frequenz von I0 bis I00 Hz zu springen. Diese Frequenzsprünge sind durch den speziellen Rückkoppelungsmechanismus bedingt und für bestimmte Anwendungen wie z.B. Heterodyn-OTDRs unbeachtlich oder sogar nützlich. Soll aber z.B. für Übertragungszwecke die Emissionsfrequenz auf die Größenordnung der Linienbreite stabilisiert werden, können vorteilhaft eine oder mehrere der folgenden Weiterbildungen der Erfindung vorgesehen sein.

Eine Unterstützung der Wirkung des erfindungsgemäß vorgesehen Monomode-LWL-Resonators erreicht man dadurch, daß an dessen Ende ein in Reflexion frequenzselektives Fabry-Perot-Etalon angeschlossen ist.

Eine insbesondere für Rückstreumeßgeräte (OTDR) geeignete besonders einfache Lösung mit einem hohen Anteil an verfügbarer optischer Nutzleistung ergibt sich dadurch, daß in den Monomode-LWL-Resonator weniger als 25 % des vom Laser gesendeten Lichts gesendet ist und daß die freie Endfläche des Monomode-LWL-Resonators reflektierend (Fresnel-Reflexion) gestaltet ist.

Besonders wirksam ist ein Fabry-Perot-Etalon dann, wenn es in den optischen Weg zwischen Laserausgang und Strahlteiler gelegt ist. Weiterhin sind vorteilhafte Maßnahmen zur Stabilisierung des Laserstroms und/oder der Temperatur des Laser-Chips vorzusehen. Zur Temperaturstabilisierung sind insbesondere integrierte Halbleiterkühler mit internem Fühler geeignet.

Durch Stabilisierungsmaßnahmen kann erreicht werden, daß sowohl Dauerstrich- als auch Puls-Halbleiterlaser stabil und schmalbandig betrieben werden können.

Die Erfindung wird anhand der Beschreibung von in der Zeichnung dargestellten vorteilhaften Ausführungsbeispielen näher erläutert.

Figur I     zeigt den schematischen Aufbau einer erfindungsgemäßen Anordnung,
            die vorwiegend in Freistrahltechnik
            aufgebaut ist.

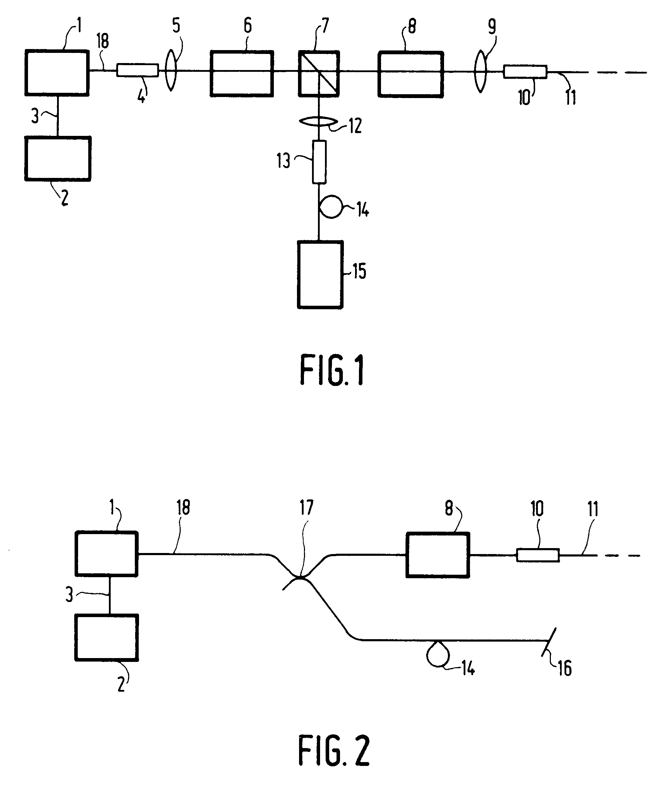

Figur 2     zeigt eine erfindungsgemäße Anordnung in Fasertechnik.

Der Halbleiterlaser I wird über die elektrischen Leitungen 3 von einer stabilisierten Stromversorgungsschaltung 2 betrieben. In die Stromversorgungsschaltung 2 kann eine Regelschaltung zur Temperaturstabilisierung integriert sein. Das Laser-"pig tail" I8 ist in eine Koppeleinrichtung 4, beispielsweise in Form eines justierbaren Faserstekkers, geführt. Das aus dem pig tail I8 gesendete Licht des Halbleiterlasers I ist über ein den Lichtstrahl verbreiterndes Objektiv, welches als Linse 5 angedeutet ist, über ein Fabry-Perot-Etalon 6 auf den Strahlteiler 7 geleitet. Von dort wird ein direkter Teil des Sendelichtstrahls über den optischen Isolator 8, das Objektiv 9 und den Koppler I0 in eine Ausgangsfaser II geleitet. Ein abgezweigter Teil des Sendelichtstrahls gelangt über die Optik I2 und den Koppler I3 in den erfindungsgemäß vorgesehenen Monomode-LWL-Resonator I4, an dessen Ende eine Meßeinrichtung I5, beispielsweise ein spektrales Meßgerät für Überwachungszwecke, angeschlossen ist.

Eine solche Meßeinrichtung kann auch zur Istwerterfassung dienen, wenn zusätzlich durch eine Regelanordnung der schmalbandige und stabile Betriebszustand aufrechterhalten werden soll.

In Figur 2 sind gleiche Teile mit der gleichen Bezugsziffer wie in Figur I bezeichnet. Der Strahlteiler ist jedoch als Faserkoppler I7 ausgebildet, an dessen einen Eingang das "pig tail"I8 des Lasers I angespleißt ist. Ein solcher Faserkoppler erfordert keinen Justieraufwand. Insbesondere aber kann er so gestaltet sein, daß nur ein relativ geringer Anteil des Sendelichtstrahls aus dem Laser-pig tail I8 in den Monomode-LWL-Resonator I4 geleitet wird.

Im Beispiel der Figur 2 ist das Ende des Monomode-LWL-Resonators I4 versumpft, wie es mit I6 angedeutet ist. Stattdessen könnte natürlich auch hier eine Meßeinrichtung I5 angeschlossen werden. Darüberhinaus wäre es möglich, die stabilisierende Wirkung des Monomode-LWL-Resonators I4 durch einen an der Stelle I6 angeschlossenes Fabry-Perot-Etalon zu verstärken, um derart ein Modenspringen zu verhindern.

Bei einer besonders einfachen Ausführung der Anordnung nach Fig. 2 endet das Ende des Monomode-LWL-Resonators I4 in Luft. Die an der Endfläche an der Stelle I6 entstehende Fresnel-Reflexion von weniger als 5% genügt zur Stabilisierung des Lasers I selbst dann, wenn über den Verzweiger I7 nur weniger als 20 % der Sendeleistung des Lasers I ausgekoppelt werden. Somit können mehr als 80% der Sendeleistung des Lasers I als Nutzleistung in den LWL II eingeleitet werden.

Bei einem vorteilhaften Ausführungsbeispiel wurde die Reflexion an der Stelle I6 durch einen sauberen Schnitt des Monomode-LWL-Resonators 4 erreicht. Es ergab sich eine Reflexion von 2%. Über den Verzweiger I7 wurden 9% der vom Pigtail I8 eines DFB-Lasers geführten Sendeleistung in den Monomode-LWL-Resonator I4 geleitet, wobei 84% der Sendeleistung als Nutzleistung in die Ausgangsfaser II gelangten. Mit dieser Anordnung konnte eine Linienbreite des Lasers I von ca. I00 kHz erzielt werden, während sein Modenabstand, welcher etwa der Länge des Monomode-LWL-Resonators I4 umgekehrt proportional ist, durch entsprechende Vorgabe dieser Länge (I bis 2 m) auf einen vorteilhaften Wert vorbestimmt wurde.

Änderungen des elektrischen Erregerstroms und der Temperatur des Lasers I können zu Modensprüngen führen, ohne daß dadurch die Linienbreite beeinflußt wird. Wegen des relativ breiten Minimums der Linienbreite in Abhängigkeit von der reflektierten Leistung sind relativ große Streubreiten des Kopplers I7 und/oder der Schnittqualität an der Stelle I6 zulässig.

Die erfindungsgemäße Anordnung war ausreichend unempfindlich gegen Polarisation und akustische Störeinflüsse.

Es ist andererseits möglich, auf einfache Weise die in den Laser I zurückreflektierte Leistung durch Änderung der Krümmung des Monomode-LWL-Resonators I4 anzupassen, z.B. durch verstärkte Krümmung zu verkleinern. Zur Erhöhung der reflektierten Lichtleistung kann an der Stelle I6, vorzugsweise über eine Anpassungsflüssigkeit zur Verhinderung von Fabry-Perot-Effekten zusätzlich ein insbesondere justierbarer Spiegel angeordnet werden.

Die Verwendung eines Faserkopplers nach Figur 2 bietet die Möglichkeit, den Verzweiger I7, den Isolator 8 und gegebenenfalls auch andere optische Bauelemente wie ein Interferometer in einem Block zu integrieren.

Da bei den erfindungsgemäßen Anordnungen die optische Wegstrecke von dem Laser-pig tail I8 bis zum optischen Isolator 8 sehr klein gehalten werden kann, da ja die Monomode-LWL-Stabilisierung über einen getrennten Nebenweg erfolgt, besteht praktisch nicht mehr die Gefahr, daß bis zum Isolator 8 undefinierte Drehungen der Polarisationsebene entstehen können. Es ist natürlich möglich, in besonders schwerwiegenden Fällen diesen optischen Verbindungsweg durch polarisationserhaltende Fasern zu überbrücken.

Die Erfindung ist vorteilhaft für Halbleiterlaser beliebiger Art geeignet, insbesondere auch für solche, die bereits konstruktionsbedingt relativ schmalbandig sind wie DFB-Laser, bei welchen dann durch den erfindungsgemäßen Resonator zusätzliche Verbesserungen erreichbar sind.

**Patentansprüche**

1. Optischer Sender mit einem Halbleiterlaser und einem externen, als Längenabschnitt eines Monomode-Lichtwellenleiter (LWL) ausgebildeten Resonator, durch welchen ein Teil des vom Halbleiterlaser gesendeten Lichts in den Halbleiterlaser zurückgekoppelt wird, dadurch gekennzeichnet, daß der Monomode-Lichtwellenleiter-Resonator (l4) an einen Abzweig eines in den Sendelichtweg geschalteten Strahlteilers (7,l7) angeschlossen ist.

2. Optischer Sender nach Anspruch l, dadurch gekennzeichnet, daß der Strahlteiler ein Faserkoppler(l7) ist.

3. Optischer Sender nach Anspruch 2, dadurch gekennzeichnet, daß in den Monomode-Lichtwellenleiter-Resonator (l4) weniger als 50 % des vom Laser gesendeten Lichts gesendet ist.

4. Optischer Sender nach einem der Ansprüche l bis 3, dadurch gekennzeichnet, daß an den Ausgang des Monomode-Lichtwellenleiter-Resonators (l4) eine Meßeinrichtung (l5) angeschlossen ist.

5. Optischer Sender nach einem der Ansprüche l bis 3, dadurch gekennzeichnet, daß an das Faserende des Monomode-Lichtwellenleiter-Resonators (l4) ein in Reflexion selektives Fabry-Perot-Etalon angeschlossen ist.

6. Optischer Sender nach einem der Ansprüche l bis 5, dadurch gekennzeichnet, daß in den optischen Weg zwischen dem Laserausgang (pig-tail l8) und Strahlteiler (7, l7) ein Fabry-Perot-Etalon (6) geschaltet ist.

7. Optischer Sender nach einem der Ansprüche l bis 6, dadurch gekennzeichnet, daß der Laserstrom stabilisiert ist.

8. Optischer Sender nach einem der Ansprüche l bis 7, dadurch gekennzeichnet, daß die Temperatur des Laser-Chips stabilisiert ist, insbesondere durch einen integrierten Halbleiterkühler mit internem Fühler.

9. Optischer Sender nach einem der Ansprüche l bis 8, dadurch gekennzeichnet, daß in den Monomode-Lichtwellenleiter-Resonator (l4) weniger als 25% des vom Laser gesendeten Lichts gesendet ist und daß die freie Endfläche des Monomode-Lichtwellenleiter-Resonators (l4) reflektierend (Fresnel-Reflexion) gestaltet ist.

**Claims**

1. An optical transmitter with a semiconductor laser and an external resonator formed as a section of a monomode optical waveguide *via* which a fraction of the light emitted by the semiconductor laser is fed back into the semiconductor laser, characterized in that the monomode optical waveguide resonator (14) is connected to a branch of a beam splitter (7, 17) arranged in the light transmission path.

2. An optical transmitter as claimed in Claim 1, characterized in that the beam splitter is a fibre coupler (17).

3. An optical transmitter as claimed in Claim 2, characterized in that less than 50% of the light emitted by the laser is coupled into the monomode optical waveguide resonator (14).

4. An optical transmitter as claimed in any one of Claims 1 to 3, characterized in that a measuring device (15) is connected to the output of the monomode optical waveguide resonator (14).

5. An optical transmitter as claimed in any one of Claims 1 to 3, characterized in that a selective Fabry-Perot etalon used in reflection is connected to the fibre end of the monomode optical waveguide resonator (14).

6. An optical transmitter as claimed in any one of Claims 1 to 5, characterized in that a Fabry-Perot etalon (6) is arranged in the optical path between the laser output (pigtail 18) and the beam splitter (7,17).

7. An optical transmitter as claimed in any one of Claims 1 to 6, characterized in that the laser current is stabilized.

8. An optical transmitter as claimed in any one of Claims 1 to 7, characterized in that the temperature of the laser chip is stabilized particularly by means of an integrated semiconductor cooler with an internal sensor.

**9.** An optical transmitter as claimed in any one of Claims 1 to 8, characterized in that less than 25% of the light emitted by the laser is coupled into the monomode optical waveguide resonator (14) and in that the free end face of the monomode optical waveguide resonator (14) is reflective (Fresnel reflection).

**Revendications**

**1.** Emetteur optique comportant un laser semiconducteur et un résonateur externe sous forme d'une partie longitudinale d'un guide d'ondes lumineuses monomode par lequel une partie de la lumière émise par le laser semiconducteur est couplée à réaction dans le laser semiconducteur, caractérisé en ce que le résonateur de guide d'ondes lumineuses monomode (14) est connecté à une branche d'un diviseur de faisceau (7, 17) monté dans le trajet de la lumière émise.

**2.** Emetteur optique selon la revendication 1, caractérisé en ce que le diviseur de faisceau est un coupleur de fibre (17).

**3.** Emetteur optique selon la revendication 2, caractérisé en ce que moins de 50% de la lumière émise par le laser est guidée dans le résonateur de guide d'ondes lumineuses monomode (14).

**4.** Emetteur optique selon l'une des revendications 1 à 3, caractérisé en ce qu'un dispositif de mesure (15) est connecté à la sortie du résonateur de guide d'ondes lumineuses monomode (14).

**5.** Emetteur optique selon l'une des revendications 1 à 3, caractérisé en ce qu'un interféromètre de Fabry-Perot sélectif en réflexion est connecté à l'extrémité de fibre du résonateur de guide d'ondes lumineuses monomode (14).

**6.** Emetteur optique selon l'une des revendications 1 à 5, caractérisé en ce qu'un interféromètre de Fabry-Perot (6) est monté dans le trajet optique entre la sortie du laser (queue de cochon 18) et le diviseur de faisceau (7, 17).

**7.** Emetteur optique selon l'une des revendications 1 à 6, caractérisé en ce que le courant de laser est stabilisé.

**8.** Emetteur optique selon l'une des revendications 1 à 7, caractérisé en ce que la température de la puce de laser est stabilisée, notamment par un refroidisseur semiconducteur intégré présentant un palpeur interne.

**9.** Emetteur optique selon l'une des revendications 1 à 8, caractérisé en ce que moins de 25% de la lumière émise par le laser est guidée dans le résonateur de guide d'ondes lumineuses monomode 14 et en ce que la face terminale libre du résonateur de guide d'ondes lumineuses monomode 14 est réalisée de façon réflectrice (réflexion de Fresnel).

FIG.1

FIG.2